(19) Europäisches Patentamt / European Patent Office / Office européen des brevets

(11) **EP 4 675 464 A1**

(12) **EUROPEAN PATENT APPLICATION**
published in accordance with Art. 153(4) EPC

(43) Date of publication:
**07.01.2026  Bulletin 2026/02**

(21) Application number: **23925437.8**

(22) Date of filing: **26.12.2023**

(51) International Patent Classification (IPC):
**G06F 17/17** (2006.01)    **G01R 23/16** (2006.01)

(52) Cooperative Patent Classification (CPC):
**G01R 23/16; G06F 17/17**

(86) International application number:
**PCT/JP2023/046545**

(87) International publication number:
**WO 2024/180887 (06.09.2024 Gazette 2024/36)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.02.2023  JP 2023029748**

(71) Applicant: **FUJITSU LIMITED**
**Kawasaki-shi, Kanagawa 211-8588 (JP)**

(72) Inventor: **KATAOKA, Yuji**
**Kawasaki-shi, Kanagawa 211-8588 (JP)**

(74) Representative: **Hoffmann Eitle**
**Patent- und Rechtsanwälte PartmbB**
**Arabellastraße 30**
**81925 München (DE)**

(54) **CALCULATION PROGRAM, CALCULATION METHOD, AND INFORMATION PROCESSING DEVICE**

(57)    [PROBLEM] Provide a calculation program, a calculation method, and an information processing device capable of estimating a baseline with high accuracy.

[SOLUTION TO PROBLEM] A calculation program causes a computer to execute a process including an acquisition process of changing a parameter for identifying a baseline to multiple values to obtain multiple estimated baselines estimated for each of the multiple values, an identification process of identifying peaks in multiple graphs that represent differences between a base data of spectral data and each of the multiple estimated baselines, and a selection process of selecting a first graph from the multiple graphs according to a number of peaks and a peak area of each of the multiple graphs, when identifying the baseline using a nonlinear least squares method for the base data.

FIG. 8A

SPECTRUM AFTER BASELINE CORRECTION
, s=13.245 FROM $\lambda = 4e^{-4}$, ratio=1e$^{-8}$

FIG. 8B

SPECTRUM AFTER BASELINE CORRECTION
, s=13.877 FROM $\lambda = 5e^{-5}$, ratio=1e$^{-9}$

FIG. 8C

SPECTRUM AFTER BASELINE CORRECTION
, s=5.072 FROM $\lambda = 7e^{-9}$, ratio=1e$^{-4}$

FIG. 8D

SPECTRUM AFTER BASELINE CORRECTION
, s=3.535 FROM $\lambda = 5e^{-5}$, ratio=1e$^{-2}$

**Description**

TECHNICAL FIELD

The present invention relates to a calculation program, a calculation method and an information processing device.

BACKGROUND ART

Spectral data may contain a baseline. To remove the baseline from the spectral data, a method using the nonlinear least squares method has been proposed (see, for example, non-patent documents 1 to 3).

CITATION LIST

NON-PATENT DOCUMENT

NON-PATENT DOCUMENT 1: P.H.C.Eilers, Anal.Chem., 75, 3631-3636 (2003).
NON-PATENT DOCUMENT 2: Z.-M. Zhang, S. Chen, and Y.-Z. Liang, Baseline correction using adaptive iteratively reweighted penalized least squares.
NON-PATENT DOCUMENT 3: Sung-June Baek, Aaron Park, Young-Jin Ahn and Jaebum Choo, Baseline correction using asymmetrically reweighted penalized least squares smoothing, Analyst, 140, 250-257 (2015).

SUMMARY OF THE INVENTION

TECHNICAL PROBLEM

However, it is difficult to estimate the baseline appropriately.
In one aspect, the present invention aims to provide a calculation program, a calculation method, and an information processing device that can estimate the baseline with high accuracy.

SOLUTION TO PROBLEM

In one aspect, a calculation program is characterized by causing a computer to execute a process including: an acquisition process of changing a parameter for identifying a baseline to multiple values to obtain multiple estimated baselines estimated for each of the multiple values, an identification process of identifying peaks in multiple graphs that represent differences between a base data of spectral data and each of the multiple estimated baselines, and a selection process of selecting a first graph from the multiple graphs according to a number of peaks and a peak area of each of the multiple graphs, when identifying the baseline using a nonlinear least squares method for the base data.

ADVANTAGEOUS EFFECTS OF INVENTION]

The baseline can be estimated with high accuracy.

BRIEF DESCRIPTION OF THE DRAWINGS

[FIG. 1] Presented is a flowchart of a baseline estimation method using a nonlinear least squares method.
[FIG. 2] (a) is a block diagram illustrating an example of an overall configuration of an information processing device, and (b) is a block diagram illustrating an example of a hardware configuration of an information processing device.
[FIG. 3] Presented is a flowchart of an example of an operation of an information processing device.
[FIG. 4] Presented is a flowchart of an example of an operation of an information processing device.
[FIG. 5] Presented is a measured spectrum obtained by X-ray absorption spectroscopy.
[FIG. 6] Presented are results obtained by estimating a baseline using nonlinear least squares method for a measured spectrum in FIG. 5.
[FIG. 7] Presented is only a corrected spectrum extracted from FIG. 6.

[FIG. 8] Presented are results when values of a parameter λ and a parameter ratio are changed.
[FIG. 9] Presented is a diagram illustrating a base data, a corrected baseline, a corrected spectrum, and a baseline.

DESCRIPTION OF EMBODIMENTS

Physical and chemical analyses such as nuclear magnetic resonance, Raman spectroscopy, infrared absorption spectroscopy, X-ray photoelectron spectroscopy, or X-ray absorption spectroscopy are performed to obtain physical and chemical information of the analytical sample. The signals (spectral data) obtained by these analyses contain a baseline and noise. The baseline and the noise prevent the acquisition of desired information. In particular, the baseline may obscure part of the desired information or bury the desired information entirely. Therefore, baseline correction is required to remove the baseline appropriately.

Conventionally, methods using differentiation and methods using polynomial fitting have been used for this baseline correction. The differentiation method is a method in which the spectrum is differentiated to highlight the peaks. The polynomial fitting method is a method in which a function that is likely to be able to express the shape of the background is used for fitting using the least squares method or the like. However, even with these methods, baseline correction can be difficult in some cases.

In recent years, a method using a nonlinear least squares method incorporating a penalty term has been proposed and its effectiveness has been recognized. In the method using the nonlinear least squares method, assuming that there is a measured value y (vertical axis of the spectrum) for x (horizontal axis of the spectrum), the evaluation function Q is expressed using the degree of fit F of the estimated value with w as a weight and the degree of smoothness R of the estimated value, and the baseline estimate z is obtained. λ is a parameter used for adjustment, and is a so-called hyperparameter.

[Equation 1]

$$x = (x_0, x_1, ..., x_i), \quad y = (y_0, y_1, ..., y_i), \quad z = (z_0, z_1, ..., z_i)$$

[Equation 2]

$$w = (w_0, w_1, ..., w_i)$$

[Equation 3]

$$F = \sum_{i=1}^{m} w_i (y_i - z_i)^2$$

[Equation 4]

$$R = \sum_{i=2}^{m} (z_i - z_{i-1})^2 = \sum_{i=1}^{m-1} (\Delta z_i)$$

[Equation 5]

$$Q = F + \lambda R = W\|y - z\|^2 + \lambda[\![Dz]\!]^2$$

[Equation 6]

$$D = \begin{bmatrix} 1 & -2 & 1 & 0 & \cdots & 0 & 0 & 0 \\ 0 & 1 & -2 & 1 & \ldots & 0 & 0 & 0 \\ \vdots & \vdots & \vdots & \vdots & \ddots & \vdots & \vdots & \vdots \\ 0 & 0 & 0 & \cdots & \cdots & 1 & -2 & 1 \end{bmatrix}$$

[Equation 7]

$$Dz = \Delta z$$

Finally, the baseline estimate Z can be expressed as the upper equation in the following equations. The weight W is a diagonal matrix, and can be expressed as the lower equation in the following equations with p as a parameter. Given the parameters $\lambda$ and p, the weight W is iteratively determined based on the lower equation, and the upper equation is solved to update the baseline estimate Z. Then, when the weight W becomes constant or reaches a preset value, the iteration ends and the final baseline estimate Z is determined.

[Equation 8]

$$z = (W + \lambda D^T D)^{-1} W y$$

[Equation 9]

$$w_i = \begin{cases} p, & y_i > z_i \\ 1 - p, & y_i \leq z_i \end{cases}$$

In order to obtain the optimal baseline estimate Z, it is necessary to optimize the parameters $\lambda$ and p, but in this case, the parameters $\lambda$ and p are always constant. However, in order to estimate the baseline estimate Z with higher accuracy, it is necessary to set the weight $w_i$ based on the difference between the original signal $y_i$ and the $z_i$ obtained in the previous iteration as expressed in the following equation.

[Equation 10]

$$F' = \sum_{i=1}^{m} w_i^t (y_i - z_i^t)^2$$

[Equation 11]

$$R' = \sum_{i=2}^{m} (z_i^t - z_{i-1}^t)^2$$

[Equation 12]

$$Q' = F' + \lambda R'$$

In this method, the weight vector W is obtained by the iteration step t as expressed in the following equations.

[Equation 13]

$$w_i^t = \begin{cases} 0, & y_i \geq z_i^{t-1} \\ e^{\frac{t(y_i - z_i^{t-1})}{|d^t|}}, & y_i < z_i^{t-1} \end{cases}$$

[Equation 14]

$$d^t = y - z^{t-1}$$

In this case, the iteration ends when the specified number of iterations or the limit expressed in the following equation is reached.

[Equation 15]

$$|d^t| < 0.001 \times |x|$$

However, even with this method, problems can occur. When the original signal is higher than the fitted baseline, that is, when the following equation is satisfied, the weight is always zero, and when the original signal is lower than the fitted baseline, the weight becomes larger.

[Formula 16]

$$y_i \geq z_i^{t-1}$$

As a result, the baseline finally obtained is estimated low in areas without peaks, and the height of the peak after baseline correction may be higher than the actual height. Therefore, a method of setting the weight as expressed in the following equation has been proposed.

[Formula 17]

$$w_i^t = \begin{cases} logistic\left(y_i - z_i^{t-1}, m_{d^-}, \sigma_{d^-}\right), & y_i < z_i^{t-1} \\ 1, & y_i \geq z_i^{t-1} \end{cases}$$

[Formula 18]

$$logistic(d^t, m, \sigma) = \frac{1}{1 + e^{\frac{2(d-(-m+2\sigma))}{\sigma}}}$$

[Formula 19]

$$d^t = y - z^{t-1}$$

[Formula 20]

$$\mathbf{d}^- : d \text{ when } y_i < z_i^{t-1}, \quad m_{\mathbf{d}^-} : \text{average of } \mathbf{d}^-, \quad \sigma_{\mathbf{d}^-} : \text{standard deviation of } \mathbf{d}^-$$

The iterations are repeated based on the preset parameter ratio until the relationship in the following equation is satisfied. The parameter ratio is a parameter related to the rate of change of the weight when performing iterative processing while varying the weight in the nonlinear least squares method.

[Equation 21]

$$\frac{|\mathbf{w}^t - w^{t-1}|}{|w^t|} < ratio$$

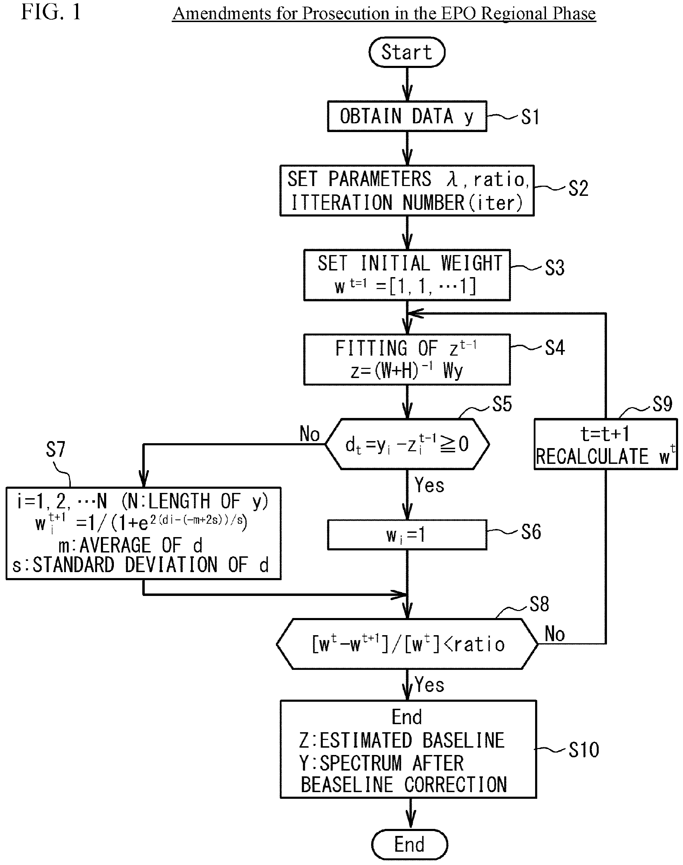

This method of setting weights as described above is considered to be the most accurate baseline estimation method among the methods using the nonlinear least squares method. FIG. 1 is a flowchart of the method.

As illustrated in FIG. 1, first, the base data y of the spectrum data is obtained (step S1). Next, the parameter $\lambda$, the parameter ratio, and the number of iterations iter are set (step S2). The number of iterations iter determines the upper limit of the iteration step t. Next, the initial weight $w^{t=1} = [1, 1, ..., 1]$ is set (step S3).

Next, fitting of $z^{t-1}$ is performed (step S4). Specifically, $z = (W + H)^{-1}Wy$. Next, it is determined whether $dt = y_i - z^{t-1}$ is equal to or greater than 0 (step S5). If the result of step S5 is "Yes", the calculator 30 sets the weight $w_i$ to 1 (step S6). If the result of step S5 is "No", it sets i = 1, 2, ..., N (N: length of y) and $w_i^{t+1} = 1/\{1 + e^{2(di-(-m+2s))/s}\}$ (step S7). Note that m is the average of d. s is the standard deviation of d.

After executing step S6 or step S7, it is determined whether $[wt - w^{t+1}] / [w^t]$ is less than the parameter ratio (step S8).

If the result of step S8 is "No," t = t + 1 is used to recalculate $w^t$ (step S9). Then, the process is repeated from step S4.

If the result of step S8 is "Yes," Z is output as the estimated baseline, and Y is output as the spectrum after baseline correction (step S10).

Compared to the method using differentiation or the method using polynomial fitting, the method using the nonlinear least squares method is more versatile, and the estimation accuracy can be improved by devising the weighting on the degree of fit F. In particular, the method using the weighting as described above shows a significant improvement in the estimated value. However, in order to estimate an appropriate baseline, it is necessary to optimize the parameters for obtaining the baseline estimation value. The criteria for optimizing the parameters have not yet been clarified, and the current situation is that a baseline that is considered appropriate is estimated subjectively through repeated trial and error. Therefore, when comparing different spectra, it is difficult to quantitatively evaluate peak intensity and the like in the spectrum after baseline correction, or to find minute differences.

In the following embodiment, an example is described in which a baseline estimate can be obtained with high accuracy by optimizing parameters for obtaining a baseline estimate in the nonlinear least squares method.

[Embodiment]

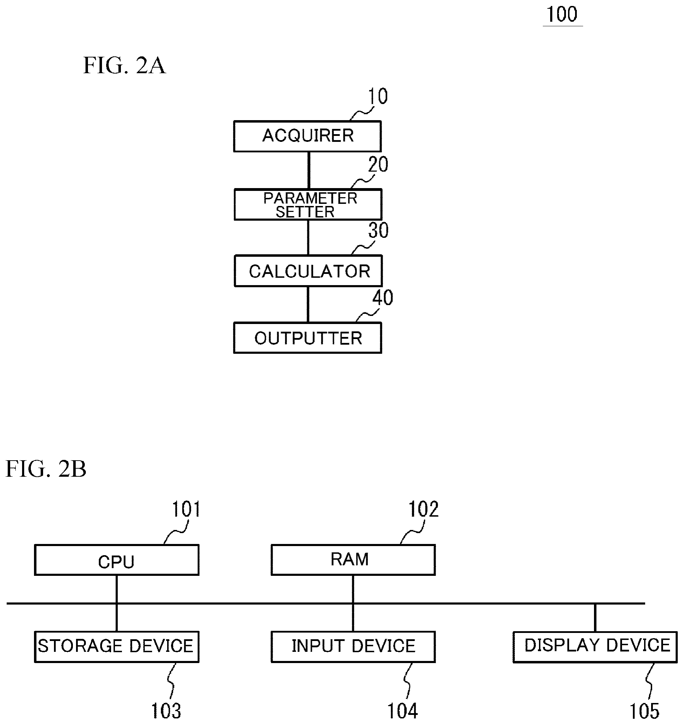

FIG. 2A is a block diagram illustrating an example of the overall configuration of an information processing device 100. As illustrated in FIG. 2A, the information processing device 100 includes an acquirer 10, a parameter setter 20, a calculator 30, and an outputter 40.

FIG. 2B is a block diagram illustrating an example of the hardware configuration of the information processing device 100. As illustrated in FIG. 2B, the information processing device 100 includes a CPU 101, a RAM 102, a storage device 103, an input device 104, a display device 105, and the like.

The CPU (Central Processing Unit) 101 is a central processing unit. The CPU 101 includes one or more cores. The RAM (Random Access Memory) 102 is a volatile memory that temporarily stores the program executed by the CPU 101, the data processed by the CPU 101, and the like. The storage device 103 is a non-volatile storage device. For example, a ROM (Read Only Memory), a solid state drive (SSD) such as a flash memory, or a hard disk driven by a hard disk drive can be used as the storage device 103. The storage device 103 stores a calculation program. The input device 104 is an input device such as a keyboard or a mouse. The display device 105 is a display device such as an LCD (Liquid Crystal Display). The CPU 101 executes the calculation program to realize the acquirer 10, the parameter setter 20, the calculator 30, the outputter 40, and the like. Note that hardware such as a dedicated circuit may be used as the acquirer 10, the parameter setter 20, the calculator 30, and the outputter 40, and the like.

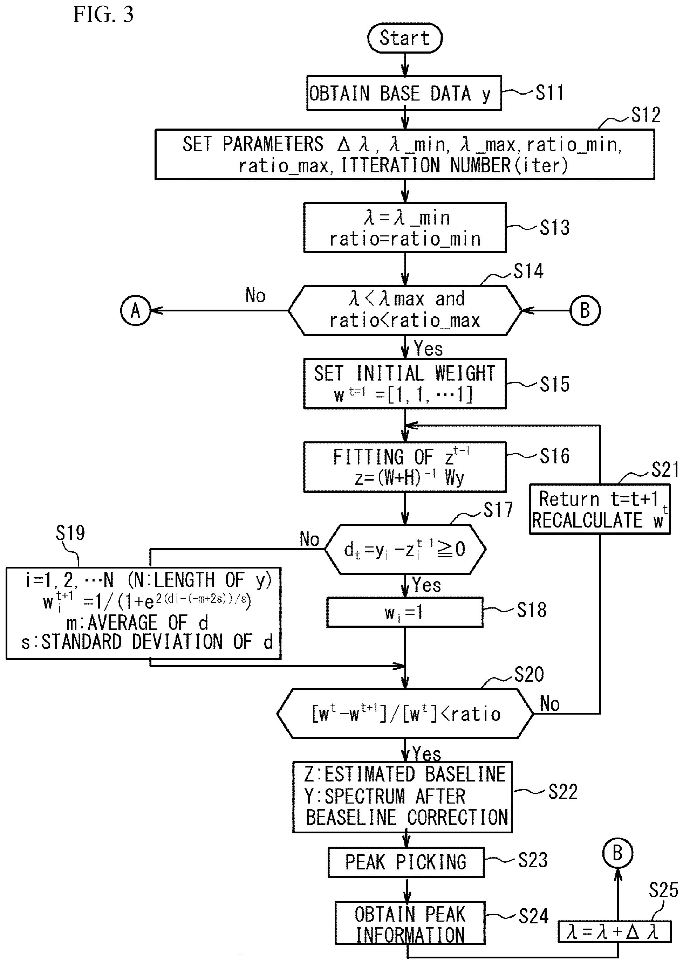

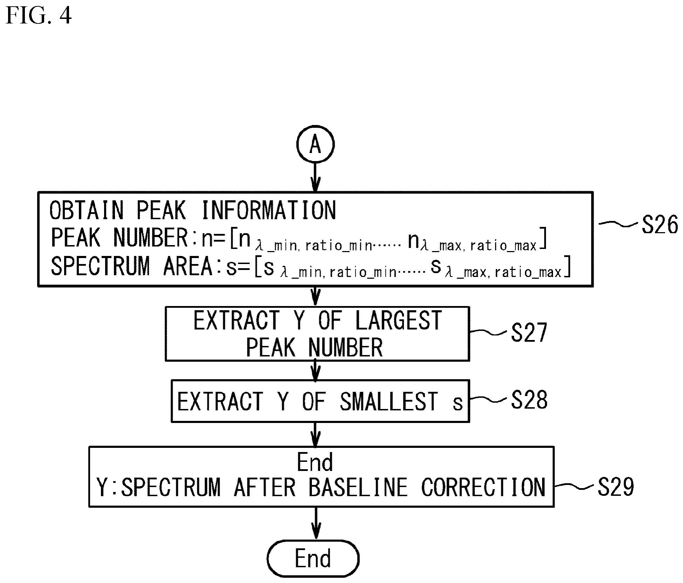

FIG. 3 and FIG. 4 are flowcharts of an example of the operation of the information processing device 100. As illustrated in FIG. 3 and FIG. 4, the acquirer unit 10 acquires base data y of the measured spectrum (step S11).

Next, the parameter setter 20 sets each parameter (step S12). Specifically, the parameter setter 20 sets $\Delta\lambda$, $\lambda\_min$, $\lambda\_max$, ratio_min, ratio_max, and the number of iterations (iter). $\lambda\_min$ is the minimum value of the parameter $\lambda$. $\lambda\_max$ is the maximum value of the parameter $\lambda$. ratio_min is the minimum value of the parameter ratio. ratio_max is the maximum value of the parameter ratio. $\Delta\lambda$ is the range of change when $\lambda$ is changed. The number of iterations iter determines the upper limit of the iteration step t.

The calculator 30 sets the parameter $\lambda$ to $\lambda\_min$ and the parameter ratio to ratio_min (step S13). By executing step S13, the initial value of the parameter $\lambda$ is set to $\lambda\_min$, and the initial value of the parameter ratio is set to ratio_min.

The calculator 30 then determines whether the parameter $\lambda$ is smaller than $\lambda\_max$ and the parameter ratio is smaller than ratio_max (step S14). By executing step S14, it is possible to confirm that the parameters $\lambda$ and ratio have not reached their upper limits.

If the result of step S14 is "Yes," the calculator 30 sets an initial weight (step S15). Specifically, the calculator 30 sets the initial weight $w^t=1$ to [1, 1, ..., 1].

The calculator 30 then performs fitting of $z^{t-1}$ (step S16). Specifically, the calculator 30 sets $z=(W+H)^{-1}Wy$.

Then, the calculator 30 judges whether $d_t = y_i - z_i^{t-1}$ is equal to or greater than 0 (step S17).

If the result of step S17 is "Yes", the calculator 30 sets the weight $w_i$ to 1 (step S18).

If the result of step S17 is "No", the calculator 30 sets i = 1, 2, ..., N (N: length of y) and $w_i^{t+1} = 1/\{1 + e^{2(di-(-m+2s))/s}\}$ (step S19). Note that m is the average of d. s is the standard deviation of d.

After executing step S18 or step S19, the calculator 30 judges whether $[w^t - w^{t+1}] / [w^t]$ is less than the parameter ratio (step S20).

If the result of step S20 is "No," the calculator 30 recalculates $w^t$ by setting t = t + 1 (step S21). Then, the process is executed again from step S16.

If the result in step S20 is "Yes," the calculator 30 sets Z as the estimated baseline and Y as the baseline-corrected correction spectrum (step S22). The correction spectrum corresponds to a graph showing the difference between the base data and the estimated baseline.

The calculator 30 then detects peaks by picking peaks in the correction spectrum Y (step S23). Specifically, the calculator 30 detects peaks in the correction spectrum and valleys formed by the peaks.

The calculator 30 then acquires spectral information on the correction spectrum Y (step S24). Specifically, the calculator 30 acquires the number of peaks n and the peak area s of the correction spectrum Y. The calculator 30 then adds $\Delta\lambda$ to $\lambda$ (step S25). After that, the process is executed again from step S14.

If the result is "No" in step S14, the calculator 30 obtains the number of peaks n = [$n_{\lambda\_min, ratio\_min}$, ..., $N_{\lambda\_max, ratio\_max}$] and the peak area s = [$s_{\lambda\_min, ratio\_min}$, ..., $s_{\lambda\_max, ratio\_max}$] (step S26).

Next, the calculator 30 extracts the corrected spectrum Y with the largest number of peaks (step S27).

Next, the calculator 30 extracts the correction spectrum Y with the smallest peak area s from among the correction spectra Y extracted in step S27 (step S28). If only one correction spectrum Y is extracted in step S27, the one correction spectrum is extracted.

Next, the outputter 40 outputs the Y extracted in steps S27 and S28 as a baseline correction spectrum (step S29). The information output by the outputter 40 is displayed on the display device 105.

According to this embodiment, when the baseline is specified using the nonlinear least squares method for the base data, the parameters for specifying the baseline are changed to multiple values, and multiple estimated baselines are repeatedly obtained for each value. This allows the parameters to be changed widely. Furthermore, peak locations are specified in multiple graphs representing the differences between the base data and each of the multiple estimated baselines, and a predetermined graph is selected from the multiple graphs according to the number of peaks and the peak area of each graph. This allows the baseline to be estimated with high accuracy. The effect will be explained below for specific spectra.

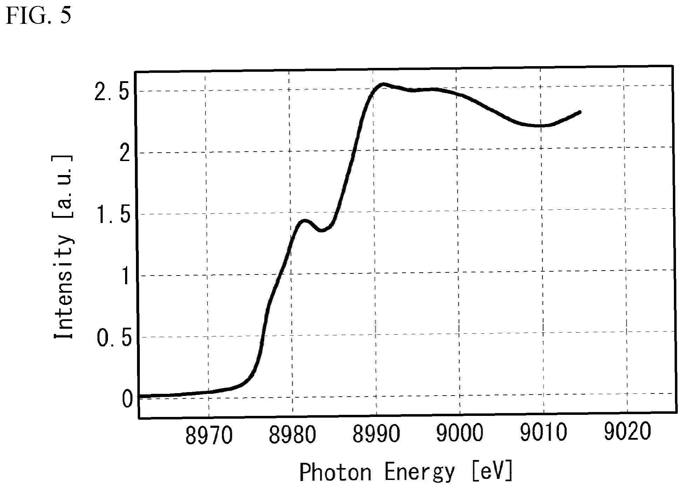

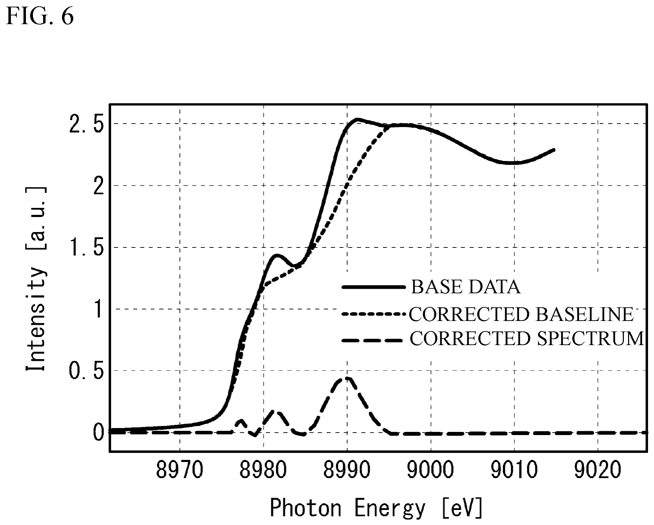

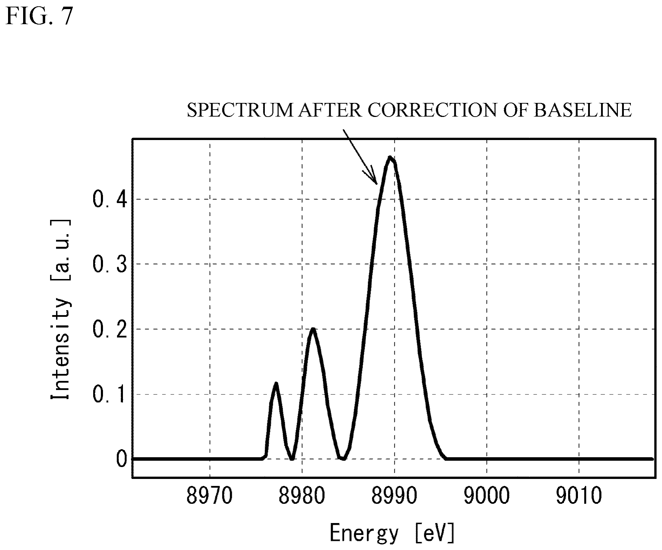

FIG. 5 is a measured spectrum obtained by X-ray absorption spectroscopy. FIG. 6 illustrates the result of estimating the baseline for the measured spectrum in FIG. 5 using the nonlinear least squares method. FIG. 7 illustrates only the corrected spectrum extracted from FIG. 6. FIG. 7 illustrates the correction result in which the peak shape of the measured spectrum is clearly maintained without losing the peaks.

However, in order to obtain the corrected spectrum illustrated in FIG. 7, it is necessary to appropriately select the parameters $\lambda$ and ratio, and trial and error is unavoidable.

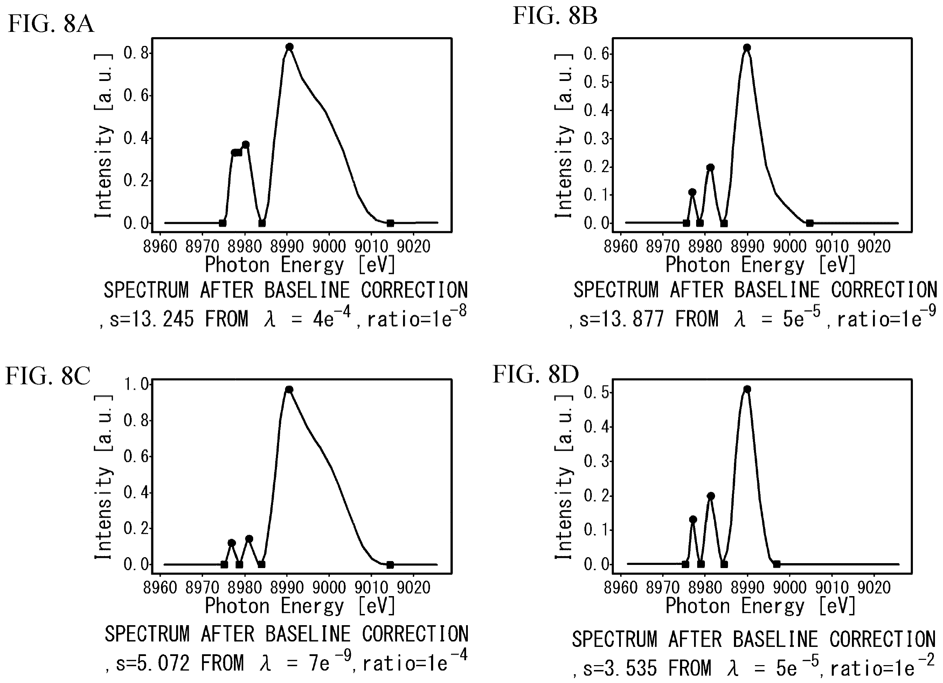

Therefore, according to this embodiment, the values of the parameter $\lambda$ and the parameter ratio are respectively changed from, for example, $1 \times e^{-2}$ to $1 \times e^{-10}$, and the baseline estimation is repeated. FIG. 8A to FIG. 8D illustrate the results when the values of the parameter $\lambda$ and the parameter ratio are changed. In each case, the number of peaks is three (circled areas), and this is the largest in the correction spectrum obtained by changing the values of the parameter $\lambda$ and the parameter ratio from $1 \times e^{-2}$ to $1 \times e^{-10}$.

Among FIG. 8A to FIG. 8D, the spectrum with the smallest peak area s of the entire spectrum is FIG. 8D. Therefore, FIG. 8D is the optimal correction spectrum.

According to this embodiment, the optimal baseline correction is possible by selecting the correction spectrum with the largest number of peaks, and then selecting the correction spectrum with the smallest peak area s from the selected correction spectrum.

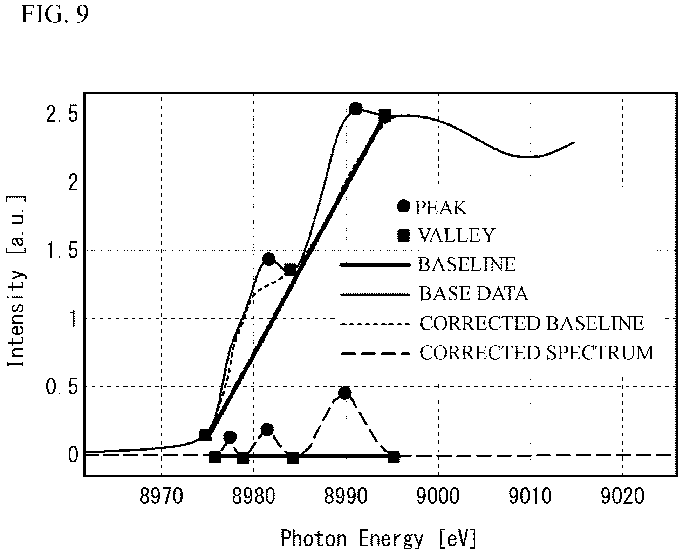

FIG. 9 is a diagram illustrating the base data, the corrected baseline, the corrected spectrum, and the baseline. The baseline is the baseline used when calculating the peak area. The peak area of the base data is the area of the region surrounded by the base data and the baseline. The peak area of the corrected spectrum is the area of the region surrounded by the corrected spectrum and the baseline.

The base data has two peaks, and the corrected spectrum has three peaks. In the corrected spectrum, there is a clear peak at 8975 eV to 8980 eV, whereas in the base data, there is only a slight bulge at that position and it is not recognized as a peak. In this way, the baseline processing according to this embodiment can bring out the buried peaks. On the other hand, there is a risk of crushing the peaks that existed before the baseline processing. Therefore, it is preferable that the number of peaks in this embodiment is limited to the number of peaks that existed before the baseline processing. Also, in consideration of bringing out the buried peaks, it is preferable that the peak area is limited to the area of the spectrum of the base data.

In the above example, when selecting a corrected spectrum, one or more corrected spectra with the maximum number of peaks are selected, and further, a corrected spectrum with the smallest peak area is selected, but this is not limited to this. For example, when selecting according to the number of peaks, a corrected spectrum with a number of peaks equal to or greater than a threshold may be selected. Also, when selecting a corrected spectrum according to the peak area, a corrected spectrum with a peak area equal to or less than a threshold may be selected. Also, in the above example, the parameters $\lambda$ and ratio are optimized, but other parameters may be optimized.

The above-described embodiment is a preferred example of the present invention. However, the present disclosure is not limited to this, and various modifications can be made without departing from the scope of the present invention.

The following supplementary notes are further disclosed in relation to the above description of the embodiment.

(Supplementary Note 1)

A calculation program characterized by causing a computer to execute a process including:
an acquisition process of changing a parameter for identifying a baseline to multiple values to obtain multiple estimated baselines estimated for each of the multiple values, an identification process of identifying peaks in multiple graphs that represent differences between a base data of spectral data and each of the multiple estimated baselines, and a selection process of selecting a first graph from the multiple graphs according to a number of peaks and a peak area of each of the multiple graphs, when identifying the baseline using a nonlinear least squares method for the base data.

(Supplementary Note 2)

The calculation program as claimed in Supplementary Note 1, characterized in that in the selection process, a graph is selected in which the number of peaks identified is equal to or greater than a threshold value.

(Supplementary Note 3)

The calculation program as claimed in Supplementary Note 1, characterized in that in the selection process, a graph is selected in which the number of peaks identified is a maximum value.

(Supplementary Note 4)

The calculation program as claimed in Supplementary Note 1, characterized in that in the selection process, among the graphs selected according to the number of peaks, a graph in which the peak area is equal to or smaller than a threshold is selected.

(Supplementary Note 5)

The calculation program as claimed in Supplementary Note 1, characterized in that in the selection process, among the graphs selected according to the number of peaks, a graph in which the peak area is a minimum value.

(Supplementary Note 6)

The calculation program as claimed in Supplementary Note 1, characterized in that the parameter includes a hyperparameter in the nonlinear least squares method.

(Supplementary Note 7)

The calculation program as claimed in Supplementary Note 1, characterized in that the parameter is a parameter related to a rate of change of a weight when performing an iterative process while varying the weight in the nonlinear least squares method.

(Supplementary Note 8)

A calculation method characterized in that a computer executes a process including:
an acquisition process of changing a parameter for identifying a baseline to multiple values to obtain multiple estimated baselines estimated for each of the multiple values, an identification process of identifying peaks in multiple graphs that represent differences between a base data of spectral data and each of the multiple estimated baselines, and a selection process of selecting a first graph from the multiple graphs according to a number of peaks and a peak area of each of the multiple graphs, when identifying the baseline using a nonlinear least squares method for the base data.

(Supplementary Note 9)

The calculation method as claimed in Supplementary Note 8, characterized in that in the selection process, a graph is selected in which the number of peaks identified is equal to or greater than a threshold value.

(Supplementary Note 10)

The calculation method as claimed in Supplementary Note 8, characterized in that in the selection process, a graph is selected in which the number of peaks identified is a maximum value.

(Supplementary Note 11)

The calculation method as claimed in Supplementary Note 8, characterized in that in the selection process, among the graphs selected according to the number of peaks, a graph in which the peak area is equal to or smaller than a threshold is selected.

(Supplementary Note 12)

The calculation method as claimed in Supplementary Note 8, characterized in that in the selection process, among the graphs selected according to the number of peaks, a graph in which the peak area is a minimum value.

(Supplementary Note 13)

The calculation method as claimed in Supplementary Note 8, characterized in that the parameter includes a hyperparameter in the nonlinear least squares method.

(Supplementary Note 14)

The calculation method as claimed in Supplementary Note 8, characterized in that the parameter is a parameter related to a rate of change of a weight when performing an iterative process while varying the weight in the nonlinear least squares method.

(Supplementary Note 15)

An information processing device characterized by comprising:

an acquirer configured to acquire a base data of a spectral data; and
a calculator configured to change a parameter for identifying a baseline to multiple values to obtain multiple estimated baselines estimated for each of the multiple values, identify peaks in multiple graphs that represent differences between the base data of spectral data and each of the multiple estimated baselines, and select a first graph from the multiple graphs according to a number of peaks and a peak area of each of the multiple graphs, when identifying the baseline using a nonlinear least squares method for the base data.

(Supplementary Note 16)

The information processing process as claimed in Supplementary Note 15 characterized in that the calculator is configured to select a graph in which the number of peaks identified is equal to or greater than a threshold value, when selecting the first graph.

(Supplementary Note 17)

The information processing process as claimed in Supplementary Note 15 characterized in that the calculator is configured to select a graph in which the number of peaks identified is a maximum value, when selecting the first graph.

(Supplementary Note 18)

The information processing process as claimed in Supplementary Note 15 characterized in that the calculator is configured to select a graph in which the peak area is equal to or smaller than a threshold, among the graphs selected according to the number of peaks.

(Supplementary Note 19)

The information processing process as claimed in Supplementary Note 15 characterized in that the calculator is configured to select a graph in which the peak area is a minimum value, among the graphs selected according to the number of peaks.

(Supplementary Note 20)

The information processing process as claimed in Supplementary Note 15 characterized in that the parameter includes a hyperparameter in the nonlinear least squares method.

(Supplementary Note 21)

The information processing process as claimed in Supplementary Note 15 characterized in that the parameter is a parameter related to a rate of change of a weight when performing an iterative process while varying the weight in the nonlinear least squares method.

Description of Symbols

10      Acquirer
20      Parameter setter
30      Calculator

| 40 | Outputter |
|---|---|
| 100 | Information processing device |
| 101 | CPU |
| 102 | RAM |
| 103 | Storage device |
| 104 | Input device |
| 105 | Display device |

**Claims**

1. A calculation program **characterized by** causing a computer to execute a process including:
   an acquisition process of changing a parameter for identifying a baseline to multiple values to obtain multiple estimated baselines estimated for each of the multiple values, an identification process of identifying peaks in multiple graphs that represent differences between a base data of spectral data and each of the multiple estimated baselines, and a selection process of selecting a first graph from the multiple graphs according to a number of peaks and a peak area of each of the multiple graphs, when identifying the baseline using a nonlinear least squares method for the base data.

2. The calculation program as claimed in claim 1, **characterized in that** in the selection process, a graph is selected in which the number of peaks identified is equal to or greater than a threshold value.

3. The calculation program as claimed in claim 1, **characterized in that** in the selection process, a graph is selected in which the number of peaks identified is a maximum value.

4. The calculation program as claimed in claim 1, **characterized in that** in the selection process, among the graphs selected according to the number of peaks, a graph in which the peak area is equal to or smaller than a threshold is selected.

5. The calculation program as claimed in claim 1, **characterized in that** in the selection process, among the graphs selected according to the number of peaks, a graph in which the peak area is a minimum value.

6. The calculation program as claimed in claim 1, **characterized in that** the parameter includes a hyperparameter in the nonlinear least squares method.

7. The calculation program as claimed in claim 1, **characterized in that** the parameter is a parameter related to a rate of change of a weight when performing an iterative process while varying the weight in the nonlinear least squares method.

8. A calculation method **characterized in that** a computer executes a process including:
   an acquisition process of changing a parameter for identifying a baseline to multiple values to obtain multiple estimated baselines estimated for each of the multiple values, an identification process of identifying peaks in multiple graphs that represent differences between a base data of spectral data and each of the multiple estimated baselines, and a selection process of selecting a first graph from the multiple graphs according to a number of peaks and a peak area of each of the multiple graphs, when identifying the baseline using a nonlinear least squares method for the base data.

9. The calculation method as claimed in claim 8, **characterized in that** in the selection process, a graph is selected in which the number of peaks identified is equal to or greater than a threshold value.

10. The calculation method as claimed in claim 8, **characterized in that** in the selection process, a graph is selected in which the number of peaks identified is a maximum value.

11. The calculation method as claimed in claim 8, **characterized in that** in the selection process, among the graphs selected according to the number of peaks, a graph in which the peak area is equal to or smaller than a threshold is selected.

12. The calculation method as claimed in claim 8, **characterized in that** in the selection process, among the graphs selected according to the number of peaks, a graph in which the peak area is a minimum value.

**EP 4 675 464 A1**

13. The calculation method as claimed in claim 8, **characterized in that** the parameter includes a hyperparameter in the nonlinear least squares method.

14. The calculation method as claimed in claim 8, **characterized in that** the parameter is a parameter related to a rate of change of a weight when performing an iterative process while varying the weight in the nonlinear least squares method.

15. An information processing device **characterized by** comprising:

> an acquirer configured to acquire a base data of a spectral data; and
> a calculator configured to change a parameter for identifying a baseline to multiple values to obtain multiple estimated baselines estimated for each of the multiple values, identify peaks in multiple graphs that represent differences between the base data of spectral data and each of the multiple estimated baselines, and select a first graph from the multiple graphs according to a number of peaks and a peak area of each of the multiple graphs, when identifying the baseline using a nonlinear least squares method for the base data.

16. The information processing device as claimed in claim 15 **characterized in that** the calculator is configured to select a graph in which the number of peaks identified is equal to or greater than a threshold value, when selecting the first graph.

17. The information processing device as claimed in claim 15 **characterized in that** the calculator is configured to select a graph in which the number of peaks identified is a maximum value, when selecting the first graph.

18. The information processing device as claimed in claim 15 **characterized in that** the calculator is configured to select a graph in which the peak area is equal to or smaller than a threshold, among the graphs selected according to the number of peaks.

19. The information processing device as claimed in claim 15 **characterized in that** the calculator is configured to select a graph in which the peak area is a minimum value, among the graphs selected according to the number of peaks.

20. The information processing device as claimed in claim 15 **characterized in that** the parameter includes a hyperparameter in the nonlinear least squares method.

21. The information processing device as claimed in claim 15 **characterized in that** the parameter is a parameter related to a rate of change of a weight when performing an iterative process while varying the weight in the nonlinear least squares method.

12

FIG. 1 <u>Amendments for Prosecution in the EPO Regional Phase</u>

```
                    ( Start )
                        |
                        v
          OBTAIN DATA y  ~S1
                        |
                        v
     SET PARAMETERS λ, ratio,  ~S2
     ITTERATION NUMBER(iter)
                        |
                        v
        SET INITIAL WEIGHT  ~S3
          w^(t=1) =[1, 1, ···1]
                        |
                        v
          FITTING OF z^(t-1)  ~S4
          z=(W+H)^(-1) Wy
                        |
                        v
```

$$d_t = y_i - z_i^{t-1} \geqq 0 \quad \text{S5}$$

No → S7:

$i = 1, 2, \cdots N$ (N:LENGTH OF y)

$$w_i^{t+1} = 1 / (1 + e^{2(di - (-m+2s))/s})$$

m:AVERAGE OF d
s:STANDARD DEVIATION OF d

Yes → $w_i = 1$ ~S6

S9: $t = t + 1$ RECALCULATE $w^t$

$$[w^t - w^{t+1}] / [w^t] < ratio \quad \text{S8}$$

No → (loop back to S9)

Yes ↓

End
Z:ESTIMATED BASELINE
Y:SPECTRUM AFTER
BEASELINE CORRECTION  ~S10

( End )

100

FIG. 2A

ACQUIRER — 10

PARAMETER SETTER — 20

CALCULATOR — 30

OUTPUTTER — 40

FIG. 2B

CPU — 101

RAM — 102

STORAGE DEVICE — 103

INPUT DEVICE — 104

DISPLAY DEVICE — 105

FIG. 3

Start

OBTAIN BASE DATA y — S11

SET PARAMETERS $\Delta\lambda$, $\lambda$_min, $\lambda$_max, ratio_min, ratio_max, ITTERATION NUMBER(iter) — S12

$\lambda=\lambda$_min
ratio=ratio_min — S13

S14
$\lambda<\lambda$max and ratio<ratio_max

No → Ⓐ

B →

Yes

SET INITIAL WEIGHT
$w^{t=1}=[1,1,\cdots1]$ — S15

FITTING OF $z^{t-1}$
$z=(W+H)^{-1}Wy$ — S16

S21
Return t=t+1
RECALCULATE $w^t$

S17
$d_t=y_i-z_i^{t-1}\geqq0$

No →

S19
$i=1,2,\cdots N$ (N:LENGTH OF y)
$w_i^{t+1}=1/(1+e^{2(di-(-m+2s))/s})$
m:AVERAGE OF d
s:STANDARD DEVIATION OF d

Yes

$w_i=1$ — S18

S20
$[w^t-w^{t+1}]/[w^t]<$ratio

No →

Yes

Z:ESTIMATED BASELINE
Y:SPECTRUM AFTER
BEASELINE CORRECTION — S22

PEAK PICKING — S23

Ⓑ

OBTAIN PEAK
INFORMATION — S24

S25
$\lambda=\lambda+\Delta\lambda$

FIG. 4

A

OBTAIN PEAK INFORMATION
PEAK NUMBER: $n = [n_{\lambda\_min, ratio\_min} \cdots\cdots n_{\lambda\_max, ratio\_max}]$
SPECTRUM AREA: $s = [s_{\lambda\_min, ratio\_min} \cdots\cdots s_{\lambda\_max, ratio\_max}]$ ～S26

EXTRACT Y OF LARGEST
PEAK NUMBER ～S27

EXTRACT Y OF SMALLEST s ～S28

End
Y: SPECTRUM AFTER BASELINE CORRECTION ～S29

End

FIG. 5

FIG. 6

FIG. 7

SPECTRUM AFTER CORRECTION OF BASELINE

EP 4 675 464 A1

FIG. 8A

SPECTRUM AFTER BASELINE CORRECTION , s=13.245 FROM $\lambda = 4e^{-4}$, ratio=$1e^{-8}$

FIG. 8B

SPECTRUM AFTER BASELINE CORRECTION , s=13.877 FROM $\lambda = 5e^{-5}$, ratio=$1e^{-9}$

FIG. 8C

SPECTRUM AFTER BASELINE CORRECTION , s=5.072 FROM $\lambda = 7e^{-9}$, ratio=$1e^{-4}$

FIG. 8D

SPECTRUM AFTER BASELINE CORRECTION , s=3.535 FROM $\lambda = 5e^{-5}$, ratio=$1e^{-2}$

FIG. 9

## INTERNATIONAL SEARCH REPORT

| International application No. |
| --- |
| **PCT/JP2023/046545** |

| A. | CLASSIFICATION OF SUBJECT MATTER |
| --- | --- |

*G06F 17/17*(2006.01)i; *G01R 23/16*(2006.01)i
FI: G06F17/17; G01R23/16 Z

According to International Patent Classification (IPC) or to both national classification and IPC

| B. | FIELDS SEARCHED |
| --- | --- |

Minimum documentation searched (classification system followed by classification symbols)

G06F17/17; G01R23/16

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | US 2021/0270742 A1 (VIRGINIA TECH INTELLECTUAL PROPERTIES, INC.) 02 September 2021 (2021-09-02) <br> entire text, all drawings | 1-21 |
| A | JP 2018-097874 A (ANDO, Hideo) 21 June 2018 (2018-06-21) <br> entire text, all drawings | 1-21 |
| A | 横田 裕海ほか、レーザー誘起ブレークダウン分光法(LIBS)による複数スペクトル同時計測データからの未知試料同定, 第38回ファジィシステムシンポジウム, 14 September 2022, pp. 667-672, [online], [retrieved on:24 January 2024], Internet <URL:http://www.jstage.jst.go.jp/article/fss/38/0/38_667/_pdf/-char/ja>, DOI https://doi.org/10.14864/fss.38.0_667, (YOKOTA, Hiromi et al. A method for identification of unknown-samples from simultaneous multi-spectrum measurement data employing Laser Induced Breakdown Spectroscopy (LIBS). 38th Fuzzy System Symposium.) <br> in particular, p. 668 | 1-21 |

☐ Further documents are listed in the continuation of Box C.   ☑ See patent family annex.

| | | |
| --- | --- | --- |
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| **24 January 2024** | **26 March 2024** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT
### Information on patent family members

International application No.

**PCT/JP2023/046545**

| Patent document cited in search report | Publication date (day/month/year) | Patent family member(s) | Publication date (day/month/year) |
|---|---|---|---|
| US 2021/0270742 A1 | 02 September 2021 | (Family: none) | |
| JP 2018-097874 A | 21 June 2018 | US 2017/0049407 A1 entire text, all drawings CN 104138249 A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **P.H.C.EILERS**. *Anal.Chem.*, 2003, vol. 75, 3631-3636
- **Z.-M. ZHANG** ; **S. CHEN** ; **Y.-Z. LIANG**. *Baseline correction using adaptive iteratively reweighted penalized least squares.*

- **SUNG-JUNE BAEK** ; **AARON PARK** ; **YOUNG-JIN AHN** ; **JAEBUM CHOO**. Baseline correction using asymmetrically reweighted penalized least squares smoothing. *Analyst*, 2015, vol. 140, 250-257